# EUROPEAN PATENT SPECIFICATION

(11) **EP 4 292 406 B1**
(45) Date of publication and mention of the grant of the patent: **09.12.2026**
(21) Application number: 21706510.1
(22) Date of filing: 15.02.2021
(51) Int. Cl.: H05K 5/02

(54) **METHOD AND APPARATUS FOR TEMPERATURE AND HUMIDITY CONTROL IN AN ELECTRICAL ENCLOSURE**
VERFAHREN UND VORRICHTUNG ZUR TEMPERATUR- UND FEUCHTIGKEITSREGELUNG IN EINEM ELEKTRISCHEN GEHÄUSE
PROCÉDÉ ET APPAREIL DE RÉGULATION DE TEMPÉRATURE ET D'HUMIDITÉ DANS UNE ENCEINTE ÉLECTRIQUE

(43) Date of publication of application: 20.12.2023
(73) Proprietor: Telefonaktiebolaget LM Ericsson (publ), 164 83 Stockholm (SE)
(72) Inventor: SNYGG, Göran, 433 43 Partille (SE); SJÖBERG, Daniel, 431 49 Mölndal (SE)
(74) Representative: Ericsson
(86) International application number: PCT/EP2021/053639
(87) International publication number: WO 2022/171310

(56) References cited:
- US-A1- 2013 278 120
- US-A1- 2017 092 405
- US-A1- 2017 094 833
- US-A1- 2018 199 453
- US-A1- 2020 313 132

## Description

### TECHNICAL FIELD

The present invention relates to a method and apparatus that employs an opening/closing mechanism for controlling temperature and humidity in an electrical enclosure.

### BACKGROUND

Telecommunication equipment is typically installed and operated outdoors. Products aimed for outdoor use are continuously exposed to different weather conditions, which can often become a serious problem as most electronics are sensitive to both high temperatures and humidity. The problem may be especially prevalent in locations having large temperature variations and/or heavy precipitation.

Water can cause severe damages on both passive and active components, e.g. resistors, capacitors, transistors, and integrated circuits. Several types of damages can occur, such as electrical short circuits, corrosion, etc. Strategies to limit the risk for these include special component packaging, electrical enclosures, indoor placement, and heating systems.

Another trend is to reduce the size of telecommunication equipment, which leads to higher temperatures inside the enclosure. Heat is a problem as basically all electrical components have their operating lifetime reduced with higher temperature. For most types of components, the aging accelerates with higher temperatures. A 10-degree difference around 20 degrees Celsius has less impact on lifetime than 10-degree difference around 70 degrees Celsius. Therefore, it is of importance to avoid high peak temperatures during operation. High temperatures could also lead to a sudden breakdown phenomenon when maximum rating for a component is reached. A combination of aging and poor derating might also cause this type of malfunction.

There are several known solutions for temperature and humidity control of electrical enclosures. For cooling it is common to use a fan that provides an airflow through the enclosure. This solution requires some type of indoor environment to avoid water penetration and fans add additional costs and have limited lifetime. Another solution without fans is based on vent holes that allow airflows around the electronics, but this solution has the drawback of not providing much protection against water penetration.

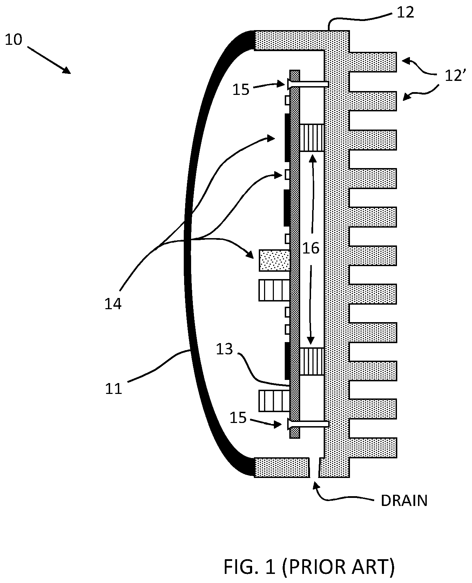

Another approach is to use a sealed enclosure in metal where the generated heat dissipates through conduction. The enclosure can also be equipped with cooling flanges to improve heat transfer. This solution is relatively expensive as it requires hermitical seals to avoid humidity penetration and water damage. Another major issue with sealed enclosures is that it is hard to remove humidity/water that has managed to penetrate the enclosure. Long-term moisture around electronics is known to cause damages. To mitigate this problem a reasonably sealed enclosure that can drain out water is sometimes used. Fig. 1 illustrates a reasonably sealed electrical enclosure with a drain hole. However, a general disadvantage of sealed structures is that they do not allow for air cooling.

Further, a known apparatus for thermal management and protection from moisture for an electronic device is disclosed in US 2018/199453 A1.

US 2020/313132 A1 discloses an outdoor electrical enclosure with adjustable vents.

US 2017/094833 A1 discloses an computer enclosure using internal electro-active elements to guide airflow.

In view of the above, there is a need to provide an electrical enclosure for outdoor use that can combine air cooling with sealed enclosures that can largely avoid water penetration.

### SUMMARY

It is an object of the present invention to remedy, or at least alleviate, some of these drawbacks and to provide an electrical enclosure that improves the temperature and humidity control.

The invention is defined by the independent patent claims.

According to a first aspect, the invention describes an electrical enclosure for outdoor use. The electrical enclosure comprises a first vent hole and a second vent hole, wherein the first and second vent holes both comprise an opening/closing mechanism. The second vent hole is further a drain hole disposed on the bottom side of the enclosure. The electrical enclosure comprises at least one sensor configured to provide sensor data, and wherein the sensor data at least comprises the temperature inside the enclosure. The electrical enclosure further comprises a control unit configured to control the operation of the opening/closing mechanism of the first and second vent holes, in which the opening/closing of the vent holes are determined based on the sensor data. The opening/closing mechanism of the first and second vent holes may use an electroactive polymer that expands in size under an applied voltage to form a seal.

According to a second aspect, the invention describes a method for temperature and humidity control in an electrical enclosure. The enclosure comprises a first vent hole and a second vent hole, and the second vent hole is further a drain hole and disposed on the bottom side of the enclosure. The method is comprising the step of reading sensor data from at least one sensor, wherein the sensor data comprises at least one of temperature, humidity, water detection inside the enclosure and rain detection outside the enclosure. The method is further comprising the step of controlling the opening/closing mechanism of the first and second vent holes based on the sensor data.

The above electrical enclosure and method improve the temperature and humidity control.by combining air cooling with a reasonably sealed enclosure that avoids water penetration.

### BRIEF DESCRIPTION OF THE DRAWINGS

Fig. 1 shows a known sealed electrical enclosure with a drain hole,
Figs. 2-3 show examples of the invention according to the first embodiment,
Fig. 4 shows schematically in a flowchart a method according to the second embodiment of the invention,
Fig. 5 shows schematically an example of a hardware implementation of the present invention.

The drawings are not necessarily to scale and the dimensions of certain features may have been exaggerated for the sake of clarity, emphasis is instead being placed upon illustrating the principle of the embodiments herein.

### DETAILED DESCRIPTION

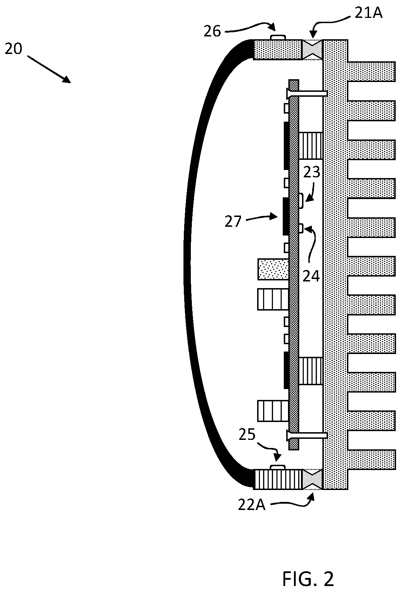

Two embodiments of the present invention are described in detail below with reference to Figs. 2-4. A first embodiment of the invention relates to an electrical enclosure 20 for outdoor use. A second embodiment relates to a method for temperature and humidity control in an electrical enclosure 20. It should be noted that the scope of the present invention is not limited to the particular embodiments described herein, but only limited by the appended claims.

The present invention relates to a method and apparatus that employs an opening/closing mechanism for controlling temperature and humidity in an electrical enclosure. The invention is preferably used for outdoor telecommunication equipment but may also be used for any type of electronic equipment that need an electrical enclosure with temperature and humidity control.

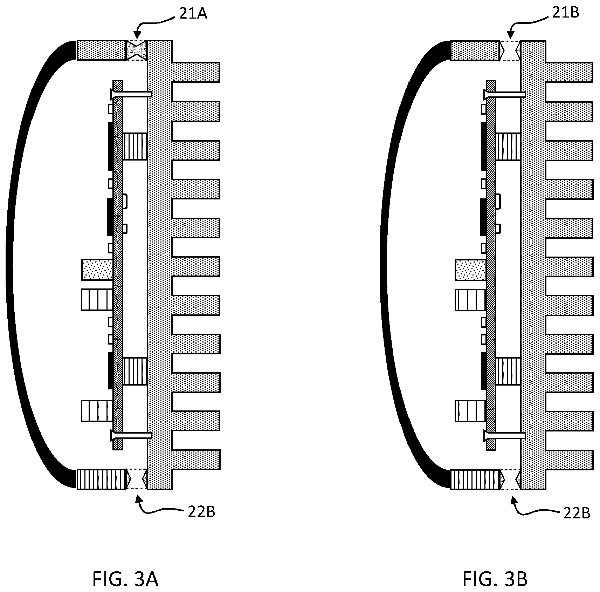

In the following, features of the first embodiment are described with reference to Figs. 2, 3A and 3B. The first embodiment relates to an electrical enclosure 20 configured for controlling temperature and humidity inside the electrical enclosure.

Several of the elements present in the known electrical enclosure 10 of Fig. 1 may also be present in the embodiment of Fig. 2. For example, a cover 11 that seals the electrical enclosure by connecting directly or via a gasket to the frame 12 or body of the electrical enclosure, a circuit board 13 comprising electrical components 14 such as resistors, capacitors, transistors and integrated circuits, screws 15 for holding the circuit board to the frame of the electrical enclosure, and heat sinks 16 that thermally connect one or several of the electrical components 14 to the frame of the electrical enclosure. The heat sinks are preferably made of aluminium, copper, or any other thermally conductive material. Likewise, the frame 12 of the electrical enclosure is suitably of a metal with high thermal conductivity. The metal frame 12 may further be equipped with cooling flanges 12' to improve heat transfer.

Figs. 2, 3A and 3B depict an electrical enclosure 20 in accordance with the first embodiment. The electrical enclosure 20 is suitable for outdoor use but may also be used in other types of environments, e.g. indoors. The electrical enclosure 20 comprises a first vent hole 21A, 21B and a second vent hole 22A, 22B, wherein the first and second vent holes both comprise an opening/closing mechanism and the second vent hole is further a drain hole disposed on the bottom side of the enclosure. The first and second vent holes may be configured to be closed 21A, 22A, or opened 21B, 22B. Preferably, the default state for the first and second vent holes are closed 21A, 22A. The bottom side here refers to lowermost part of the electrical enclosure during operation, thus allowing water to drain out of the electrical enclosure when the second vent hole is open 22B. Preferably, the first and second vent holes are disposed on opposite sides of the enclosure, i.e. bottom and the top side. This configuration takes advantage of the chimney effect to cool the inside of the electrical enclosure. The chimney effect may be further improved by adding vertical cooling flanges inside the electrical enclosure.

The electrical enclosure 20 comprises at least one sensor 23, 24, 25, 26 configured to provide sensor data, and wherein the sensor data at least comprises the temperature inside the enclosure, obtained from a temperature sensor 23. For improved temperature control an additional temperature sensor on the outside of the enclosure may be added. The sensor data may also comprise the humidity inside the enclosure, obtained from a humidity sensor 24. The sensor data may further comprise water detection data indicating if water is detected inside the enclosure, obtained from a water detection sensor 25. Additionally, the sensor data may yet further comprise rain detection data, obtained from a rain detection sensor 26 outside the enclosure.

The electrical enclosure 20 comprises a control unit 27 for controlling the opening/closing mechanism of the first and second vent holes. The control unit may be implemented as a microcontroller or as any other type of programmable logic or integrated circuit. Alternatively, the control unit may be implemented remotely. The control unit is connected, physically or wirelessly, to the opening/closing mechanisms of the first and second vent holes 21A, 21B, 22A, 22B. The control unit is further configured to control the operation of the opening/closing mechanism of the first and second vent holes based on the sensor data. For example, the control unit may be configured to open the first and the second vent holes 21B, 22B when the temperature inside the enclosure is above a predetermined temperature threshold, providing an airflow through the enclosure and thus avoiding overheating. High humidity might be an indication of water inside the electrical enclosure. Hence, in another example, the control unit 27 may be configured to open the second vent hole 22B, or both vent holes 21B, 22B, to drain out water, when the humidity inside the electrical enclosure is above a predetermined humidity threshold. In yet another example, the control unit may be configured to open the second vent hole 22B when the water detection sensor indicates water inside the enclosure. The control unit may yet further be configured to close the first vent hole 21A when the rain detection sensor 26 indicates rain outside the electrical enclosure. The above described variants of the first embodiment show how sensor data and the control unit enable an improved air cooling and protection against water penetration.

The opening/closing mechanism of the first and second vent holes 21A, 21B, 22A, 22B of the electrical enclosure 20 preferably uses an electroactive polymer that expands in size under an applied voltage to form a seal, thus allowing the control unit 27 to control whether each vent hole is opened 21B, 22B or closed 21A, 22A. The expanded electroactive polymer provides a reasonably sealed enclosure that can avoid water penetration. The electroactive polymer may also be combined with a gasket to further improve the seal of the closed vent hole 21A, 22A.

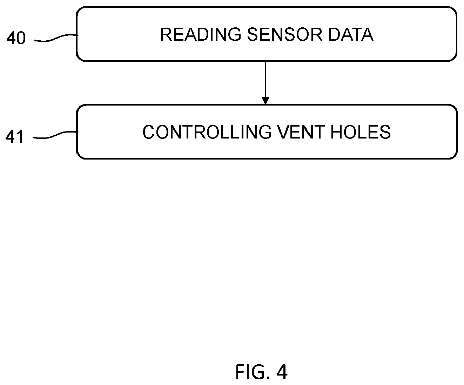

In the following, features of the second embodiment are described with reference to Fig. 4. The second embodiment relates to a method that employs an opening/closing mechanism for controlling temperature and humidity in an electrical enclosure 20.

The method is performed for an electrical enclosure, the electrical enclosure comprising a first vent hole 21A, 21B and a second vent hole 22A, 22B, wherein the second vent hole is further a drain hole and disposed on the bottom side of the enclosure.

The method comprises the step of reading 40 sensor data from at least one sensor 23, 24, 25, 26, wherein the sensor data comprises at least one of temperature data, humidity data, water detection inside the enclosure and rain detection outside the enclosure. Alternatively, the sensor data always comprises temperature data.

The method further comprises the step of controlling 41 an opening/closing mechanism for the first and second vent holes 21A, 21B, 22A, 22B based on said sensor data. The step of controlling 41 may comprise opening the first and the second vent holes 21B, 22B when the temperature inside the enclosure is above a predetermined temperature threshold. The controlling 41 may also comprise opening the second vent hole 22B, or both vent holes 21B, 22B, when the humidity inside the enclosure is above a predetermined humidity threshold, as this may be an indication of water inside the enclosure. The controlling 41 may further comprise opening the second vent hole 22B when a water detection sensor 25 indicates water inside the enclosure. The controlling 41 may yet further comprise closing the first vent hole 21A when the rain detection sensor 26 indicates rain outside the enclosure.

According to another aspect, the invention relates to one or several structures in electroactive polymers that control the vent holes of the electrical enclosure. Electroactive polymers are used in artificial muscles for its ability to change size or shape when stimulated by an electric field. Hence, it is possible to use electroactive polymers to control the opening/closing mechanism of the vent hole. Airflows inside the enclosure can then be controlled by opening and closing the first and/or second vent holes. With a vent hole on the bottom and another vent hole on the top of the enclosure, the airflow can be further improved by the so-called chimney effect. The need of extended cooling occurs normally during high peak temperatures. When it is raining the temperature is significantly lower and there is often no need of extended cooling. In fact, rain gives the electrical enclosure additional cooling capacity due to its cooling effect. With a temperature sensor inside the housing the control unit can determine whether the vent holes need to open or stay closed. By using external and/or internal humidity sensors, the humidity rate can be monitored, and the control unit can be configured to determine whether the vent holes need to open or stay closed. In one example, the vent holes are open to provide an airflow through the enclosure as long as the outside air is dry. In another example, the control unit opens the second vent hole to drain out water that has penetrated the electrical enclosure when the internal humidity sensor indicates humidity rate above a predetermined threshold. This may further be done in a controlled way when the temperature conditions are optimal.

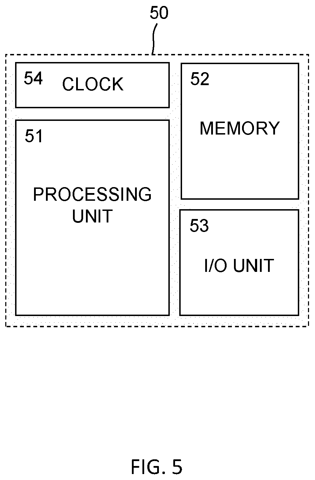

According to yet another aspect of the invention, the control unit 27 may be implemented as a processing unit 51, a memory 52, input/output unit 53 and a clock 54 as is illustrated in Fig. 5. The processing unit 51, the memory 52, the I/O unit 53 and the clock 54 may be interconnected. The processing unit 51 may comprise a central processing unit, a digital signal processor, a multiprocessor system, programmable logic, a field programmable gate array (FPGA) or an application specific integrated circuit (ASIC) or any other type of logic. The memory 502 may comprise random access memory (RAM), read only memory (ROM) or any other type of volatile or non-volatile memory. The I/O unit 53 may comprise circuitry for output control signals and may further be connected, physically or wirelessly, to the opening/closing mechanisms of the first and second vent holes 21A, 21B, 22A, 22B.

It should be emphasized that the term "comprises/comprising" when used in this specification is taken to specify the presence of stated features, integers, steps or components, but does not preclude the presence or addition of one or more other features, integers, steps, components or groups thereof. It should also be noted that the words "a" or "an" preceding an element do not exclude the presence of a plurality of such elements.

## Claims

1. An electrical enclosure (20) for outdoor use, the electrical enclosure comprising a first vent hole (21A, 21B) and a second vent hole (22A, 22B), wherein the first and second vent holes both comprise an opening/closing mechanism and the second vent hole is further a drain hole disposed on the bottom side of the enclosure, wherein the electrical enclosure (20) comprises:
- at least one sensor (23, 24, 25, 26) configured to provide sensor data, and wherein the sensor data at least comprises the temperature inside the enclosure, and
- a control unit (27) configured to control the operation of the opening/closing mechanism of the first and second vent holes (21A, 21B, 22A, 22B), in which the opening/closing of the vent holes are determined based on the sensor data,
wherein the opening/closing mechanism of the first and second vent holes (21A, 21B, 22A, 22B) uses an electroactive polymer that expands in size under an applied voltage to form a seal.

2. The electrical enclosure (20) of claim 1, wherein the sensor data further comprises the humidity inside the enclosure.

3. The electrical enclosure (20) of claims 1-2, wherein the sensor data further comprises water detection data indicating if water is detected inside the enclosure.

4. The electrical enclosure (20) of claims 1-3, wherein the sensor data further comprises data on rain detection outside the enclosure.

5. The electrical enclosure (20) of claims 1-4, wherein the control unit (27) is configured to open the first and the second vent holes (21B, 22B) when the temperature inside the enclosure is above a predetermined temperature threshold.

6. The electrical enclosure (20) of claims 2-5, wherein the control unit (27) is configured to open the second vent hole (22B) when the humidity inside the enclosure is above a predetermined humidity threshold.

7. The electrical enclosure (20) of claims 3-6, wherein the control unit (27) is configured to open the second vent hole (22B) when the water detection sensor (25) indicates water inside the enclosure.

8. The electrical enclosure (20) of claims 4-7, wherein the control unit is configured to close the first vent hole (21) when the rain detection sensor (26) indicates rain outside the enclosure.

9. The electrical enclosure (20) of claim 1-8, wherein the first and second vent holes are disposed on opposite sides of the enclosure.

10. A method for temperature and humidity control in an electrical enclosure (20), the enclosure comprising a first vent hole (21) and a second vent hole (22), wherein the second vent hole is further a drain hole and disposed on the bottom side of the enclosure, the method comprising the steps of:
- reading (40) sensor data from at least one sensor (23, 24, 25, 26), wherein the sensor data comprises at least one of temperature, humidity, water detection inside the enclosure and rain detection outside the enclosure, and
- controlling (41) an opening/closing mechanism of the first and second vent holes (21, 22) based on the sensor data,
wherein the opening/closing mechanism of the first and second vent holes (21, 22) uses an electroactive polymer that expands in size under an applied voltage to form a seal.

11. The method of claim 10, wherein the sensor data comprises temperature and controlling (41) comprises opening the first and the second vent holes (21B, 22B) when the temperature inside the enclosure is above a predetermined temperature threshold.

12. The method of claim 10-11, wherein the sensor data comprises humidity and controlling (41) comprises opening the second vent hole (22B) when the humidity inside the enclosure is above a predetermined humidity threshold.

13. The method of claim 10-12, wherein the sensor data comprises water detection inside the electrical enclosure and controlling (41) comprises opening the second vent hole (22B) when the sensor data indicates water inside the electrical enclosure.

14. The method of claim 11-13, wherein the sensor data comprises rain detection outside the electrical enclosure and controlling (41) comprises closing the first vent hole (21A) when the sensor data indicates rain outside the electrical enclosure.

## Patentansprüche

1. Elektrisches Gehäuse (20) zu Außenanwendung, wobei das elektrische Gehäuse eine erste Entlüftungsöffnung (21A, 21B) und eine zweite Entlüftungsöffnung (22A, 22B) umfasst, wobei die erste und zweite Entlüftungsöffnung jeweils ein Öffnungs-/Schließmechanismus umfassen und die zweite Entlüftungsöffnung weiter eine Ablauföffnung ist, die auf der Unterseite des Gehäuses angeordnet ist, wobei das elektrische Gehäuse (20) umfasst:
- mindestens einen Sensor (23, 24, 25, 26), der dafür konfiguriert ist, Sensordaten zu liefern, und wobei die Sensordaten mindestens die Temperatur innerhalb des Gehäuses umfassen, und
- eine Steuerungseinheit (27), die dafür konfiguriert ist, den Betrieb des Öffnungs-/Schließmechanismus der ersten der und zweiten Entlüftungsöffnung (21A, 21B, 22A, 22B) zu steuern, wobei Öffnen/Schließen der Entlüftungsöffnungen auf Grundlage der Sensordaten bestimmt wird,
wobei der Öffnungs-/Schließmechanismus der ersten und zweiten Entlüftungsöffnung (21A, 21B, 22A, 22B) ein elektroaktives Polymer verwendet, das sich unter einer angelegten Spannung in der Größe ausdehnt, um eine Abdichtung zu bilden.

2. Elektrisches Gehäuse (20) nach Anspruch 1, wobei die Sensordaten weiter die Feuchtigkeit innerhalb des Gehäuses umfassen.

3. Elektrisches Gehäuse (20) nach den Ansprüchen 1-2, wobei die Sensordaten weiter Wassererkennungsdaten umfassen, die anzeigen, ob Wasser innerhalb des Gehäuses erkannt wird.

4. Elektrisches Gehäuse (20) nach den Ansprüchen 1-3, wobei die Sensordaten weiter Daten zur Regenerkennung außerhalb des Gehäuses umfassen.

5. Elektrisches Gehäuse (20) nach den Ansprüchen 1-4, wobei die Steuerungseinheit (27) dafür konfiguriert ist, die erste und die zweite Entlüftungsöffnung (21B, 22B) zu öffnen, wenn die Temperatur innerhalb des Gehäuses oberhalb eines vorbestimmten Temperaturschwellenwerts liegt.

6. Elektrisches Gehäuse (20) nach den Ansprüchen 2-5, wobei die Steuerungseinheit (27) dafür konfiguriert ist, die zweite Entlüftungsöffnung (22B) zu öffnen, wenn die Feuchtigkeit innerhalb des Gehäuses oberhalb eines vorbestimmten Feuchtigkeitsschwellenwertes liegt.

7. Elektrisches Gehäuse (20) nach den Ansprüchen 3-6, wobei die Steuerungseinheit (27) dafür konfiguriert ist, die zweite Entlüftungsöffnung (22B) zu öffnen, wenn der Wassererkennungssensor (25) Wasser innerhalb des Gehäuses anzeigt.

8. Elektrisches Gehäuse (20) nach den Ansprüchen 4-7, wobei die Steuerungseinheit dafür konfiguriert ist, die erste Entlüftungsöffnung (21) zu schließen, wenn der Regenerkennungssensor (26) Regen außerhalb des Gehäuses anzeigt.

9. Elektrisches Gehäuse (20) nach Anspruch 1-8, wobei die erste und zweite Entlüftungsöffnung auf gegenüberliegenden Seiten des Gehäuses angeordnet sind.

10. Verfahren zur Temperatur- und Feuchtigkeitssteuerung in einem elektrischen Gehäuse (20), wobei das Gehäuse eine erste Entlüftungsöffnung (21) und eine zweite Entlüftungsöffnung (22) umfasst, wobei die zweite Entlüftungsöffnung weiter eine Ablauföffnung ist und auf der Unterseite des Gehäuses angeordnet ist, wobei das Verfahren die folgenden Schritte umfasst:
- Auslesen (40) von Sensordaten von mindestens einem Sensor (23, 24, 25, 26), wobei die Sensordaten mindestens eine von Temperatur, Feuchtigkeit, Wassererkennung innerhalb des Gehäuses und Regenerkennung außerhalb des Gehäuses umfassen, und
- Steuern (41) eines Öffnungs-/Schließmechanismus der ersten und zweiten Entlüftungsöffnung (21, 22) auf Grundlage der Sensordaten,
wobei der Öffnungs-/Schließmechanismus der ersten und zweiten Entlüftungsöffnung (21, 22) ein elektroaktives Polymer verwendet, das sich unter einer angelegten Spannung in der Größe ausdehnt, um eine Abdichtung zu bilden.

11. Verfahren nach Anspruch 10, wobei die Sensordaten Temperatur umfassen und Steuern (41) Öffnen der ersten und der zweiten Entlüftungsöffnung (21B, 22B) umfasst, wenn die Temperatur innerhalb des Gehäuses oberhalb eines vorbestimmten Temperaturschwellenwertes liegt.

12. Verfahren nach Anspruch 10-11, wobei die Sensordaten Feuchtigkeit umfassen und Steuern (41) Öffnen der zweiten Entlüftungsöffnung (22B) umfasst, wenn die Feuchtigkeit innerhalb des Gehäuses oberhalb eines vorbestimmten Feuchtigkeitsschwellenwerts liegt.

13. Verfahren nach Anspruch 10-12, wobei die Sensordaten Wassererkennung innerhalb des elektrischen Gehäuses umfassen und Steuern (41) Öffnen der zweiten Entlüftungsöffnung (22B) umfasst, wenn die Sensordaten Wasser innerhalb des elektrischen Gehäuses anzeigen.

14. Verfahren nach Anspruch 11-13, wobei die Sensordaten Regenerkennung außerhalb des elektrischen Gehäuses umfassen und Steuern (41) Schließen der ersten Entlüftungsöffnung (21A) umfasst, wenn die Sensordaten Regen außerhalb des elektrischen Gehäuses anzeigen.

## Revendications

1. Enceinte électrique (20) destinée à un usage extérieur, l'enceinte électrique comprenant un premier trou d'aération (21A, 21B) et un second trou d'aération (22A, 22B), dans laquelle les premier et second trous d'aération comprennent tous deux un mécanisme d'ouverture/de fermeture et le second trou d'aération est en outre un trou d'évacuation disposé sur le côté inférieur de l'enceinte, dans laquelle l'enceinte électrique (20) comprend :
- au moins un capteur (23, 24, 25, 26) configuré pour fournir des données de capteur, et dans laquelle les données de capteur comprennent au moins la température à l'intérieur de l'enceinte, et
- une unité de commande (27) configurée pour commander le fonctionnement du mécanisme d'ouverture/de fermeture des premier et second trous d'aération (21A, 21B, 22A, 22B), dans laquelle le mécanisme d'ouverture/de fermeture des trous d'aération est déterminé sur la base des données de capteur,
dans laquelle le mécanisme d'ouverture/de fermeture des premier et second trous d'aération (21A, 21B, 22A, 22B) utilise un polymère électroactif qui se dilate sous une tension appliquée pour former un joint.

2. Enceinte électrique (20) selon la revendication 1, dans laquelle les données de capteur comprennent en outre l'humidité à l'intérieur de l'enceinte.

3. Enceinte électrique (20) selon les revendications 1-2, dans laquelle les données de capteur comprennent en outre des données de détection d'eau indiquant si de l'eau est détectée à l'intérieur de l'enceinte.

4. Enceinte électrique (20) selon les revendications 1-3, dans laquelle les données de capteur comprennent en outre des données de détection de pluie à l'extérieur de l'enceinte.

5. Enceinte électrique (20) selon les revendications 1-4, dans laquelle l'unité de commande (27) est configurée pour ouvrir les premier et second trous d'aération (21B, 22B) lorsque la température à l'intérieur de l'enceinte est supérieure à un seuil de température prédéterminé.

6. Enceinte électrique (20) selon les revendications 2-5, dans laquelle l'unité de commande (27) est configurée pour ouvrir le second trou d'aération (22B) lorsque l'humidité à l'intérieur de l'enceinte est supérieure à un seuil d'humidité prédéterminé.

7. Enceinte électrique (20) selon les revendications 3-6, dans laquelle l'unité de commande (27) est configurée pour ouvrir le second trou d'aération (22B) lorsque le capteur de détection d'eau (25) indique de l'eau à l'intérieur de l'enceinte.

8. Enceinte électrique (20) selon les revendications 4-7, dans laquelle l'unité de commande est configurée pour fermer le premier trou d'aération (21) lorsque le capteur de détection de pluie (26) indique de la pluie à l'extérieur de l'enceinte.

9. Enceinte électrique (20) selon la revendication 1-8, dans laquelle les premier et second trous d'aération sont disposés sur des côtés opposés de l'enceinte.

10. Procédé de commande de température et d'humidité dans une enceinte électrique (20), l'enceinte comprenant un premier trou d'aération (21) et un second trou d'aération (22), dans lequel le second trou d'aération est en outre un trou d'évacuation et disposé sur le côté inférieur de l'enceinte, le procédé comprenant les étapes de :
- lecture (40) de données de capteur provenant d'au moins un capteur (23, 24, 25, 26), dans lequel les données de capteur comprennent au moins une parmi la température, l'humidité, la détection d'eau à l'intérieur de l'enceinte et la détection de pluie à l'extérieur de l'enceinte, et
- commande (41) d'un mécanisme d'ouverture/de fermeture des premier et second trous d'aération (21, 22) sur la base des données de capteur,
dans lequel le mécanisme d'ouverture/de fermeture des premier et second trous d'aération (21, 22) utilise un polymère électroactif qui se dilate sous une tension appliquée pour former un joint.

11. Procédé selon la revendication 10, dans lequel les données de capteur comprennent la température et la commande (41) comprend l'ouverture des premier et second trous d'aération (21B, 22B) lorsque la température à l'intérieur de l'enceinte est supérieure à un seuil de température prédéterminé.

12. Procédé selon la revendication 10-11, dans lequel les données de capteur comprennent l'humidité et la commande (41) comprend l'ouverture du second trou d'aération (22B) lorsque l'humidité à l'intérieur de l'enceinte est supérieure à un seuil d'humidité prédéterminé.

13. Procédé selon la revendication 10-12, dans lequel les données de capteur comprennent la détection d'eau à l'intérieur de l'enceinte électrique et la commande (41) comprend l'ouverture du second trou d'aération (22B) lorsque les données de capteur indiquent la présence d'eau à l'intérieur de l'enceinte électrique.

14. Procédé selon la revendication 11-13, dans lequel les données de capteur comprennent la détection de pluie à l'extérieur de l'enceinte électrique et la commande (41) comprend la fermeture du premier trou d'aération (21A) lorsque les données de capteur indiquent de la pluie à l'extérieur de l'enceinte électrique.
